# EUROPÄISCHE PATENTSCHRIFT

(11) **EP 1 088 118 B1**
(45) Veröffentlichungstag und Bekanntmachung des Hinweises auf die Patenterteilung: **07.08.2002**
(21) Anmeldenummer: 99924821.4
(22) Anmeldetag: 24.04.1999
(51) Int. Cl.: C23C 28/04, C23C 16/00, C23C 16/40

(54) **VERFAHREN ZUM AUFBRINGEN EINER SCHMIERSTOFFSCHICHT AUF EINEN GEGENSTAND SOWIE GEGENSTAND MIT HAFTENDER SCHMIERSTOFFSCHICHT**
METHOD FOR APPLYING A LUBRICATING LAYER ON AN OBJECT AND OBJECT WITH AN ADHESIVE LUBRICATING LAYER
PROCEDE D'APPLICATION D'UNE COUCHE LUBRIFIANTE SUR UN OBJET, ET OBJET COMPORTANT UNE COUCHE LUBRIFIANTE ADHESIVE

(30) Priorität: 22.05.1998 DE 19822934
(43) Veröffentlichungstag der Anmeldung: 04.04.2001
(73) Patentinhaber: DaimlerChrysler AG, 70567 Stuttgart (DE)
(72) Erfinder: FÜSSER, Hans-Jürgen, D-89547 Gerstetten (DE)
(86) Internationale Anmeldenummer: EP9902791
(87) Internationale Veröffentlichungsnummer: WO9961682

(56) Entgegenhaltungen:
- Surface and Coatings Technology, Band 76-77, 1995, A. Erdemir et al, "Formation and self-lubricating mechanisms of boric acid on borided steel surfaces" Seite 443 - Seite 449, XP002900662
- Appl.Phys.Lett., Band 68, Nr. 7, Februar 1996, C. Bindal et al, "Ultralow friction behavior of borided steel surfaces after flash annealing" Seite 923 - Seite 925, XP002900661
- Journal of the Society of Tribologists and Lubricaiton Engineers, Band 47, Nr. 3, 1990, A. Erdemir et al, "Tribological Properties of Boric Acid and Boric-Acid-Forming Surfaces. Part II: Mechanisms of Formation and Self-Lubrication of Boric Acid Films on Boron-and Boric Oxide-Containing Suraces" Seite 179 - Seite 184, XP002900660

## Beschreibung

Die Erfindung betrifft ein Verfahren zum haftenden Aufbringen einer Schmierstoffschicht auf eine freiliegende und tribologisch beanspruchte Oberfläche eines Gegenstandes sowie einen Gegenstand mit an einer freiliegenden Oberfläche haftenden Schmierstoffschicht gemäß den Oberbegriffen der Ansprüche 1 bzw. 30, wie beides bspw. aus dem gattungsbildend zugrundegelegten Artikel "Formation and self-lubricating mechanisms of boric acid on borided steel surfaces" von A. Erdemir et al in Surface & Coating Technology 76-77, 1995, Seite 443 - 449 als bekannt hervorgeht.

Aus dem Artikel "Formation and self-lubricating mechanisms of boric acid on borided steel surfaces" von A. Erdemir et al in Surface & Coating Technology 76-77, 1995, Seite 443 - 449 ist eine Beschichtung eines Trockenschmiermittels aus Borsäure auf Stählen bekannt sowie ein Verfahren zur Aufbringung der Beschichtung. Bei dem aus dieser Schrift vorbekannten Verfahren wird ein Stahl zuerst boriert. Die borierte Oberfläche des Stahls weist eine gute Härte und Korrosionsbeständigkeit auf. Allerdings ist ihr Reibwert (Reibkoeffizient) sehr hoch. Daher wird die borierte Oberfläche des Stahles mit einer Schmierstoffschicht aus Borsäure versehen, die als Trockenschmiermittel wirkt. Zum Borieren wird der Stahl in ein Salzbad getaucht, das eine Borverbindung aufweist und das auf 940 °C erhitzt wird. Nach dem Salzbad wird der borierte Stahl auf 750 °C erhitzt, wodurch die Boratome tiefer in den Oberflächenbereich des Stahles diffundieren können. Es wird vermutet, dass einige der Atome auch an die freie Oberfläche diffundieren, wo sie bei Anwesenheit von Sauerstoff sofort zu Boroxid reagieren. Dadurch scheidet sich an der Oberfläche des Stahls eine Boroxidschicht ab, die beim späteren Abkühlen und in Anwesenheit von Wasserstoff in Borsäure umgewandelt wird. Zur Bildung des Boroxids darf die Temperatur allerdings nicht unter 750 °C abgesenkt werden und der borierte Stahl auch nicht länger als 8 min auf diese Temperatur erhitzt sein, da sich ansonst kein Boroxid bildet. Abgesehen davon, dass diese Temperaturbehandlung eine immense Belastung für den Stahl darstellt, ist auch die Prozeßführung zur Herstellung der Boroxid-Schicht sehr empfindlich, weshalb das vorbekannte Verfahren auch sehr aufwendig, kompliziert und teuer ist. Desweiteren sind mit diesem Verfahren endformnahe, insbesondere genau bemaßte Bauteile nur sehr schwer und mit einer großen Ausschussrate herzustellen. Auch ist das gesamte Verfahren insbesondere für veränderte Schichtdicken sehr inflexibel.

Aus dem Artikel "A study of the formation and self-lubrication mechanisms of boric acid folms on boric oxide caotings" von A. Erdemir et al in Surface & Coating Technology 43/44, 1990, Seite 588 - 596 ist ebenfalls eine Beschichtung eines Trockenschmiermittels aus Borsäure sowie ein Verfahren zur Auftragung dieser Beschichtung bekannt. Bei diesem Verfahren wurden die 0-berflächen eines Gegenstandes aus α-Aluminiumoxid und eines Gegenstandes aus Stahl (M50) durch einen Argon-Ionenstrahl gereinig und anschließend mittels einer Elektronenstrahlverdampfung im Vakuum mit dem Boroxid beschichtet. Die Reibkoeffizienten der einige µm dicken Schmierstoffschichten waren in beiden Fällen sehr gut, wobei allerdings die Standzeit der Beschichtung auf Stahl gering war. Des weitern ist die Haftung der Schmierstoffschichten aus Borsäure auf den Substraten gering, so dass auch dieses Verfahren eine hohe Ausschussrate aufweist.

Aus dem Artikel "Ultralow friction behavior of borided steel after flash annealing", von C. Bindal et al, in Appl. Phys. Lett., Bd. 68, Nr. 7, Feb. 1996, Seite 923 - 925, ist ein Schmelzborierverfahren von Stahlsubstraten bei 800-1000°C mit nachfolgender Temperaturbehandlung bei 750°C bekannt, wodurch eine FeB und Fe₂B enthaltene Boridschicht, mit einer Boroxid-Zwischenschicht mit darauf gebildeter Borsäureschicht erhalten wird.

Aus dem Artikel "Tribological Properties of Boric Acid and Boric-Acid-Forming Surfaces. Part II: Mechanisms of Formation and Self-Lubrication of Boric Acid Films on Boron- and Boric Oxid-Containing Surfaces" von A. Erdemir et al, in Journal of the Society of Tribologists and Lubrication Engineers, Bd. 47, Nr. 3, 1990, Seite 179-184, ist ein Verfahren zur Herstellung von mit Borsäure als Trockenschmiermittel beschichteten Stahlsubstraten bekannt, wobei hier zusätzlich eine Zwischenschicht aus Boroxiden aufgebracht wird. Als Abscheideverfahren wurden die beiden PVD-Verfahren Elektronenstrahlverdampfung von Boroxid sowie Sputtern von Bor, das durch eine Reaktion mit Sauerstoff Boroxid bildet, verwendet.

Die Aufgabe der Erfindung ist es, ein Verfahren anzugeben, mit dem ein insbesondere metallischer Gegenstand in preisgünstiger Weise und innerhalb geringer Herstellungstoleranzen sowie bei kleinen Ausschußraten mit einer guthaftenden Schmierstoffschicht aus einem Trockenschmiermittel versehen werden kann, wobei das Trockenschmiermittel einen möglichst geringen Reibwert und eine möglichst lange Standzeit aufweisen soll. Desweiteren ist es Aufgabe der Erfindung für einen insbesondere metallischen Gegenstand eine guthaftende Schmierstoffschicht aus einem Trockenschmiermittel zu entwickeln, welche Schmierstoffschicht preisgünstig und innerhalb geringer Herstellungstoleranzen sowie mit kleinen Ausschußraten aufgebracht ist, wobei das Trockenschmiermittel einen möglichst geringen Reibwert und eine möglichst hohe Standzeit aufweist.

Die Aufgabe wird erfindungsgemäß mit einem Verfahren mit den Verfahrensschritten des Anspruchs 1 bzw. mit einer Beschichtung mit den Merkmalen des Anspruchs 30 gelöst. Durch den erfindungsgemäßen Schichtaufbau und die Aufbringung der einzelnen Schichten, bevorzugt mittels eines Plasma-CVD-Verfahrens, können die Schichtdicken in einfacher Weise im µm-Berich reproduzierbar aufgebracht werden, so dass zumindest eine aufwendige Nachbearbeitung entfällt. Desweiteren ist die Haftung auf dem Gegenstand durch das erfindungsgemäße Vorgehen verbessert.

Sinnvolle Ausgestaltungen der Erfindung sind den jeweiligen Unteransprüchen entnehmbar. Im übrigen wird die Erfindung anhand von Beispielen und nachfolgenden Zeichnungen näher erläutert. Dabei zeigt
- Fig. 1: einen Ausschnitt eines Schnittes durch einen erfindungsgemäßen Schichtaufbau eines beschichteten Gegenstandes,
- Fig. 2: ein Diagramm des Reibkoeffizienten in Abhängigkeit der Zeit bei mit unterschiedlichen Trockenschmiermitteln beschichteten Gegenständen bei einem Schwingverschleißtest,
- Fig. 3: eine Vorrichtung zur Herstellung der erfindungsgemäßen Beschichtung und
- Fig. 4: ein Gasflußdiagramm bei der Herstellung einer erfindungsgemäßen Beschichtung.

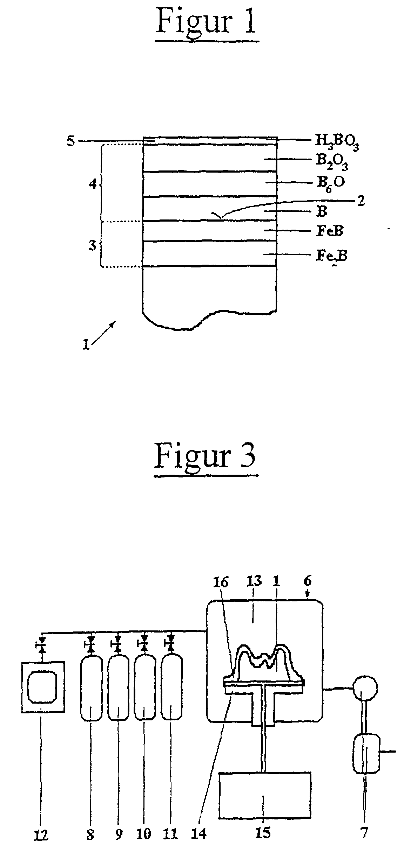

In Figur 1 ist ein Ausschnitt eines Schnittes durch einen erfindungsgemäßen Schichtaufbau eines beschichteten Gegenstandes 1 dargestellt, wobei der Maßstab stark verzerrt ist. Der aus Stahl hergestellte metallische Gegenstand 1 weist im Bereich seiner nach außen gerichteten und mit der Beschichtung bedeckten Oberfläche 2 eine borierte Haftvermittlerschicht 3 mit Boriden des Werkstoffs des Gegenstandes 1 auf. Im vorliegenden Fall sind innerhalb der Haftvermittlerschicht 3 Boride des Eisens angeordnet. Innen beginnend liegt zuerst zumindest vermehrt Fe₂B und anschließend FeB vor.

Anstelle einer reinen Borierung können zur Herstellung der Haftvermittlerschicht 3 die oberflächennahen Bereiche des Gegenstandes 1 auch nitriert und/oder carboniert und/oder carbonitriet werden. Derartige Haftvermittlerschichten 3 können zusätzlich auch noch boriert werden. Anstelle eines Gegenstandes 1 aus Stahl kann auch einen Gegenstand aus einem anderen Werkstoff, vorzugsweise jedoch aus einem Tiund/oder Al- und/oder Mg-Werkstoff, mit der erfindungsgemäßen Beschichtung versehen werden.

Auf der zuvor freiliegenden Oberfläche 2 des Gegenstandes 1 folgt der Haftvermittlerschicht 3 eine Zwischenschicht 4, die Bor und dessen Oxide aufweist. Insbesondere weist die Zwischenschicht 4 - beginnend von der zuvor freiliegenden Oberfläche 2 des Gegenstandes 1 - zuerst zumindest vorwiegend Bor, nachfolgend zumindest vorwiegend B₆O und zuletzt B₂O₃ auf. Auf dem B₂O₃ ist die Borsäure (H₃BO₃) aufweisende Schmierstoffschicht 5 angeordnet, wobei die Anteil der Borsäure in der Schmierstoffschicht 5 zumindest oberflächennah mindestens 5%, bevorzugt 10 % und besonders bevorzugt 30 % beträgt.

Die als Trockenschmiermittel verwendete Borsäure kann insbesondere erst oder auch zusätzlich, insbesondere bei einem Verschleiß der bisherigen Borsäure aufweisenden Schmierstoffschicht 5, im Einsatzfall durch eine oberflächennahe Umwandlung des B₂O₃ bei Anwesenheit von Wasser bzw. Wasserstoff gebildet werden. In vorteilhafter Weise kann also die Bor und Sauerstoff, insbesondere B₂O₃, aufweisende Zwischenschicht 4 im Verschleißfall eine Art Reservoir für die Borsäure der Schmierstoffschicht 5 bilden.

In Figur 2 ist ein Diagramm des Reibkoeffizienten in Abhängigkeit der Zeit bei mit unterschiedlichen Trockenschmiermitteln beschichteten Gegenständen dargestellt, welche einem Schwingvergleichstest unterzogen wurden.

Die einzelnen Kurven betreffen Gegenstände aus folgenden Werkstoffen:
Kurve A: einen Gegenstand 1 mit einem erfindungsgemäßen Schichtaufbau mit einer Schmierstoffschicht aus Borsäure,
Kurve B: eine Molybdensulfid-Schicht (MoS₂) auf einem Gegenstand aus einem Hartmetall,
Kurve C: amorpher Diamant auf einem Gegenstand aus einem Hartmetall und
Kurve D: eine Wolframcarbid/Graphitschicht auf einem Gegen stand aus einem Hochleistungs-Schnell-Schneidestahl.

Die Versuche wurden in trockenen Zustand, d.h. ohne zusätzliche, insbesondere flüssige Schmierung durchgeführt. Als Testkörper wurde eine Kugel aus 100Cr6 mit einem Radius von 4 mm verwendet, die mit einer Last von 5 N auf das beschichtete Substrat aufgepreßt und auf einer Länge von 600 µm mit einer Frequenz von 10 kHz hin- und herbewegt wurde.

Der mit der WC/C-Schicht beschichtete Gegenstand 1 (Kurve D) weist einen Verlauf des Reibkoeffizienten auf, der sich nach einem anfänglichen Einlaufverhalten bei Werten zwischen 0.2 und 0.3 einstellt. Dieser Wert wird innerhalb der genannten Bandbreite etwas über 100 Minuten gehalten und steigt anschließend an. Bei ca. 4000 Minuten beträgt er etwa 0.45.

Der mit dem amorphen Diamanten beschichtete Gegenstand 1 (Kurve C) weist einen Verlauf des Reibkoeffizienten auf, der sich nach einem anfänglichen etwa zehnminutigen Einlaufverhalten, bei dem die Werte des Reibkoeffizienten zwischen etwa 0.1 und 0.35 an- und abschwellen, auf einen Wert von ca. 0.1 einstellt. Ab diesem Zeitpunkt nimmt der Wert des Reibkoeffizienten mit zunehmender Beanspruchungszeit stetig zu. Wie aus dem Diagramm nach Figur 2 ersichtlich ist, steigt der Wert des Reibkoeffizienten nach 10 Minuten innerhalb von ca. 190 min von etwa 0.1 auf etwa 0.2 an.

Der mit MoS₂ beschichtete Gegenstand 1 (Kurve B) weist einen Verlauf des Reibkoeffizienten auf, der sich nach einem sehr kurzen Einlaufverhalten, auf einen Wert zwischen etwa 0.05 und etwa 0.1 einstellt. Dieser Wert des Reibkoeffizienten wird innerhalb der oberen Bandbreite etwa 100 Minuten gehalten und steigt anschließend innerhalb sehr kurzer Zeit auf Werte über 0.4 an. Dies bedeutet, daß das Material ein sehr gutes Kurzeitverhalten aber ein sehr schlechtes Langzeitverhalten aufweist.

Der den erfindungsgemäßen Schichtaufbau aufweisende Gegenstand 1 (Kurve A) weist nach einem anfänglichen etwa einminütigen Einlaufverhalten einen Verlauf des Reibkoeffizienten auf, der sich auf einen Wert von etwa 0.05 einstellt. Dieser Wert des Reibkoeffizienten wird unverändert über die gesamte Zeit gehalten. Insbesondere sei hier erwähnt, das der Wert des Reibkoeffizienten sogar nach einer Versuchszeit die länger als die im Diagramm aufgeführte Zeit von 10.000 min war, immer noch stabil blieb.

In Figur 3 ist eine Vorrichtung in der Art einer Plasma-CVD-Anlage dargestellt, die zur Durchführung des erfinderischen Verfahrens, mit dem der erfindungsgemäße Schichtaufbau realisierbar ist, geeignet ist.

Die Vorrichtung weist einen Reaktor 6 auf, der durch ein fluidisch mit ihm verbundenes Pumpsystem 7 evakuierbar ist. Ferner weist der Reaktor 6 ein Gasversorgungssystem mit mehreren Gasflaschen 8 - 11 und einen Verdampfer 12 auf. Das Gasversorgungssystem ist ebenso wie das Pumpsystem 7 zu- und abschaltbar. Die Gasflaschen 8 - 11 und der Verdampfer 12 können einzeln und mit einem regelbaren Gasstrom mit dem Innenraum 13 des Reaktors 6 verbunden werden. In den Gasflaschen 8 - 11 sind bspw. die Prozeßgase, ein ein Plasma 16 unterstützendes Gas und/oder auch Vormaterialien für den erfindungsgemäßen Schichtaufbau gespeichert. Insbesondere handelt es sich u, die Gase Methan, Diboran, Wasserstoff, Sauerstoff und Stickstoff.

Innerhalb des Reaktors 6 ist ein Substrathalter 14 angeordnet, auf dem ein zu beschichtender Gegenstand 1 angeordnet werden kann. Der Substrathalter 14 ist zur Spannungsversorgung elektrisch leitend mit einem Generator 15 verbunden. Der zur Plasmaerzeugung vorgesehene Generator 15 kann bspw. mit elektrischer Wechselspannung, mit einer Wechselspannung mit gekappter Halbwelle, vorzugsweise mit einer gepulsten Gleichspannung betrieben werden.

Zur Herstellung eines erfindungsgemäßen Schichtaufbaus wird der zu beschichtende Gegenstand 1 in den Reaktor 6 eingebaut und das Reaktorinnere 13 auf einen Druck kleiner 100 mbar, bevorzugt kleiner 10 mbar und besonders bevorzugt auf etwa 1 mbar evakuiert. Nach dem Evakuieren wird im Reaktorinnern 13 der erreichte Unterdruck gehalten. Gegebenenfalls kann das Reaktorinnere 13 auch zumindest teilweise wieder mit einem Inertgas befüllt werden.

Anschließend wird an dem Generator 15 eine gewünschte Puls-Spannung hinsichtlich ihrer Amplitude und ihrer Frequenz eingestellt und an den elektrisch leitend mit dem Generator 15 verbundenen Gegenstand 1 angelegt. Vorzugsweise wird eine Spannung gewählt, die bezogen auf den den Gegenstand 1 umgebenden Gasraum und insbesondere auch gegenüber Masse negativ ist.

Danach wird das Prozeßgas zur Herstellung der Haftvermittlerschicht 3, die zur Verbesserung der Haftung zwischen der später aufgetragenen Schmierstoffschicht 5 und dem Material des Gegenstandes 1 oder zur Verbesserung der Haftung zwischen einer anschließend aufgebrachten Zwischenschicht 4 und dem Material des Gegenstandes 1 dient, eingeleitet.

Die Haftvermittlerschicht 3 wird günstigerweise durch Borieren und/oder Nitrieren und/oder Carbonisieren und/oder Carbonitrieren erzeugt, welche Prozesse zweckmäßigerweise durch ein Plasma 16 unterstützt werden. Hierbei werden überschüssige Gaspartikel von dem Pumpsystem 7 entfernt.

Anstelle oder ergänzend zu dem obigen Prozeß kann zur Herstellung der Haftvermittlerschicht 3 das bzw. die betreffenden Substanzen auch mittels Ionenimplantation in die oberflächennahen Bereiche der zu beschichtenden Oberfläche 2 des Gegenstandes 1 eingebracht werden.

Als Ersatzmaßnahme oder als ergänzende Maßnahme zu der/den oben genannten Haftvermittlerschichten 3 kann auf der zu beschichtenden Oberfläche 2 des Gegenstandes 1 und zwar als Haftvermittlerschicht 3 oder als Bestandteil der Haftvermittlerschicht 3 insbesondere TiN und/oder TiC und/oder Ti(C,N) und/oder eine Borcarbid-Schicht (B₄C) abgeschieden werden.

Das unterstützende Plasma 16 wird aus der Zusammenwirkung der gepulsten elektrischen Spannung und Wasserstoff, der hierzu extra in das Reaktorinnere 13 eingeleitet wird, und/oder dem Prozeßgas erzeugt. Bevorzugt wird das Plasma 16 so erzeugt, daß es die zu beschichtende Oberfläche 2 des Gegenstandes 1 umhüllt und ggf. auch zumindest teilweise in Vertiefungen, wie Bohrungen und dergleichen, des Gegenstandes 1 eintaucht. Vorzugsweise wird das Plasma 16 im Bereich der Oberfläche des Gegenstandes 1 erzeugt.

In günstiger Weise beheizt das Plasma 16 zumindest die zu beschichtende Oberfläche 2 des Gegenstandes 1 auf Temperaturen kleiner 750 °C, vorzugsweise kleiner 700 °C und besonders bevorzugt kleiner 600 °C, da hier allenfalls eine geringe Änderung des Gefüges des Werkstoffes des Gegenstandes 1 zu erwarten ist.

Die Pulsrate der elektrischen Spannung hat u.a. eine Auswirkung auf die räumlich Gestalt des Plasma 16. Daher wird die Pulsrate und ggf. auch die gewählte elektrische Spannung zweckmäßigerweise in Abhängigkeit zu der körperlichen Ausgestaltung der zu beschichtenden Oberfläche 2 des Gegenstandes 1 eingestellt.

Bei den Prozeßgase handelt es zweckmäßiger um Gase, die das Element bzw. die Elemente enthalten, die zur Herstellung der Haftvermittlerschicht 3 benötigt werden. Dies kann bspw. dadurch erfolgen, daß das Prozeßgas das bzw. die betreffende Element(e) in reiner Form aufweist und/oder daß das bzw. die betreffende Element(e) bei Prozeßbedingungen aus dem Prozeßgas als Dissoziationsprodukt und/oder als Ion zur Verfügung gestellt werden.

Als Prozeßgas werden in den obigen Fällen Prozeßgase verwendet, die Bor und/oder Stickstoff und/oder Kohlenstoff zumindest als Verbindung aufweisen und/oder bei Prozeßbedingungen das entsprechende Element freigeben.

Bei einer Borierung handelt es sich bei dem Prozeßgas bevorzugt um Borane (BₙHₘ), vorzugsweise um Diboran (B₂H₆), um Borchlorid (BCl₃) oder um Borfluorid (BF₃) oder um ein Gemisch aus zumindest zweien dieser Gase.

Bei einem Fe aufweisenden Gegenstand 1 wird beim Borieren insbesondere Fe₂B und das gegenüber dem FeB₂ sprödere und daher zumeist unerwünschte FeB gebildet. Eine besonders gute Haftung der nachfolgenden Schicht wird erreicht, wenn das FeB im Verhältnis zu allen Eisenboriden mit einem Anteil kleiner 20 %, bevorzugt kleiner 10 % und besonders bevorzugt kleiner 1% gebildet wird.

Um dies in einfacher Weise zu realisieren kann insbesondere der Anteil von Bor in der abscheidenden Gasphase nach der Bildung von Fe₂B im Bereich der zu beschichtenden Oberfläche 2 des Gegenstandes 1 innerhalb von 5 s um wenigstens 20 % erhöht und/oder die oberflächennahe Temperatur des Gegenstandes 1 abgesenkt werden.

Auf der Haftvermittlerschicht 3 wird sinnvollerweise eine Zwischenschicht 4 angeordnet. Hierzu wird als zweites Vormaterial ein Gas in das Reaktorinnere 13 und in das Plasma 16 eingeleitet, das Bor zumindest als Verbindung aufweist und bei Prozeßbedingungen das Bor freigibt.

Wie schon bei der Haftvermittlerschicht 3 werden hierzu insbesondere Borane (BₙHₘ), vorzugsweise Diboran (B₂H₆), Borchlorid (BCl₃) oder Borfluorid (BF₃) oder ein Gemisch aus zumindest zweien dieser Gase verwendet.

Desweiteren wird zur Bildung der Zwischenschicht 4 ein Sauerstoff zumindest als Verbindung aufweisendes und bei Prozeßbedingungen den Sauerstoff freigebendes erstes vormaterial in die abscheidende Gasphase eingeleitet.

Aus diesen beiden Vormaterialien wird die Bor und Sauerstoff aufweisende Zwischenschicht 4 auf der Haftvermittlerschicht 3 abgeschieden.

Durch die Variation der Temperatur und/oder des Sauerstoffs kann hierbei der Anteil des Sauerstoff in der Zwischenschicht 4 gesteuert werden, so daß der Anteil von Sauerstoff innerhalb der Zwischenschicht 4 einen Gradienten aufweist.

Vorzugsweise nimmt der Anteil von Sauerstoff mit zunehmendem Abstand von der Haftvermittlerschicht 3 zu. Bevorzugt wird die Zwischenschicht 5 mit Boroxid, insbesondere als B₆O und/oder B₂O₃ aufgetragen, wobei vorzugsweise zuerst B₆O und anschließend B₂O₃ aufgetragen wird. Vor der Aufbringung der Boroxide wird auf die Haftvermittlerschicht 3 sinnvollerweise zumindest weitgehend reines Bor aufgetragen.

Analog zur Herstellung der Haftvermittlerschicht 3 wird hierbei der Gegenstand 1 während des Abscheidens der Bor und Sauerstoff aufweisenden Zwischenschicht 4 insbesondere auf Temperaturen kleiner 750 °C, vorzugsweise kleiner 700 °C und besonders bevorzugt kleiner 600 °C beheizt.

Im Bereich der freiliegenden Oberfläche 2 der Zwischenschicht 4 wird zuletzt die Schmierstoffschicht 5 aus Borsäure (H₃BO₃) angeordnet. Diese Schmierstoffschicht 5 kann mit den Gasen Wasserstoff, Sauerstoff und Bor gleich innerhalb des Reaktors 6 hergestellt werden.

Ebenso ist es innerhalb des Reaktors 6 möglich, die oberflächennahen Bereiche der Bor und Sauerstoff aufweisenden Zwischenschicht 4 durch Reaktion mit Wasserstoff in Borsäure umzuwandeln oder die Bor und Sauerstoff aufweisenden Zwischenschicht 4 gleich bei Ihrer Herstellung aus der Gasphase zumindest teilweise in Borsäure umzuwandeln. In beiden Fällen wird zweckmäßigerweise zumindest oberflächennah die Temperatur des Gegenstandes 1 gesenkt.

Ersatzweise ist es auch möglich, daß diese Schmierstoffschicht 5 erst bei Anwesenheit von Wasserstoff und/oder Wasserdampf im Einsatz des Gegenstandes 1 gebildet wird. In diesem Fall wird durch eine chemische Reaktion der oberflächennahen Bereiche der Bor und Sauerstoff aufweisenden Zwischenschicht 4 mit dem Wasserstoff der Atmosphäre zu der Borsäure aufweisenden Schmierstoffschicht 5 umgesetzt. Diese Reaktion wird insbesondere noch durch die beim Einsatz entstehende Wärme gefördert. In diesem Fall stellen zumindest gewisse Bereiche der Bor und Sauerstoff aufweisenden Zwischenschicht ein Reservoir zur Nachgewinnung von verschlissener oder auf sonst eine Art entfernter Borsäure dar.

In allen Fällen weist die Schmierstoffschicht 5 sinnvollerweise mindestens 80 %, bevorzugt mindestens 90 % und besonders bevorzugt mindestens 95 % Borsäure auf.

In vorteilhafter Weise wird nicht nur während der Herstellung der Haftvermittlerschicht 3 sondern auch bei der Herstellung der Bor und Sauerstoff aufweisenden Zwischenschicht 4 und/oder der Schmierstoffschicht 5 innerhalb des Reaktors 6 an den Gegenstand 1 eine gepulste DC-Spannung angelegt, die gegenüber dem den Gegenstand 1 umgebenden Gasraum ein negatives elektrisches Potential aufweist.

Mit einer gemäß Anspruch 1 aufgetragenen Beschichtung können insbesondere abrasiv beanspruchte Laufflächen von Maschinenbauteilen, vorzugsweise Motorbauteile und besonders bevorzugt Nockenwellen, Kipphebel, Tassenstößel, Laufbuchsen, Ventilbrücken, Ventilschäfte, Ventillaufbuchsen bzw. - führungen, Kolbenbolzen, Kolbenringe, Zylinderlaufflächen, Pleuel, Anlaufscheiben, ferner Zahnräder, insbesondere von Getrieben, Kettenglieder oder Riemenscheiben für stufenlose Getriebe, desweiteren spanend eingreifende Spanflächen spanabhebender Werkzeuge mit definierten Schneidengeometrien wie Fräser, Drehstähle, Wendeschneideplatten, Bohrer, und auch Werkzeuge zum Reiben und Räumen sowie abrasiv beanspruchte Formwerkzeuge, insbesondere Umformwerkzeuge wie Tiefziehpressen in vorteilhafter Weise zumindest bereichsweise mit einer sinnvollen und gut haftenden tribologischen Beschichtungen versehen werden.

Bei allen Anwendungen ist von besonderem Vorteil, daß ein sonst notwendige Schmierung mit Flüssigschmiermitteln zumindest verringert werden kann.

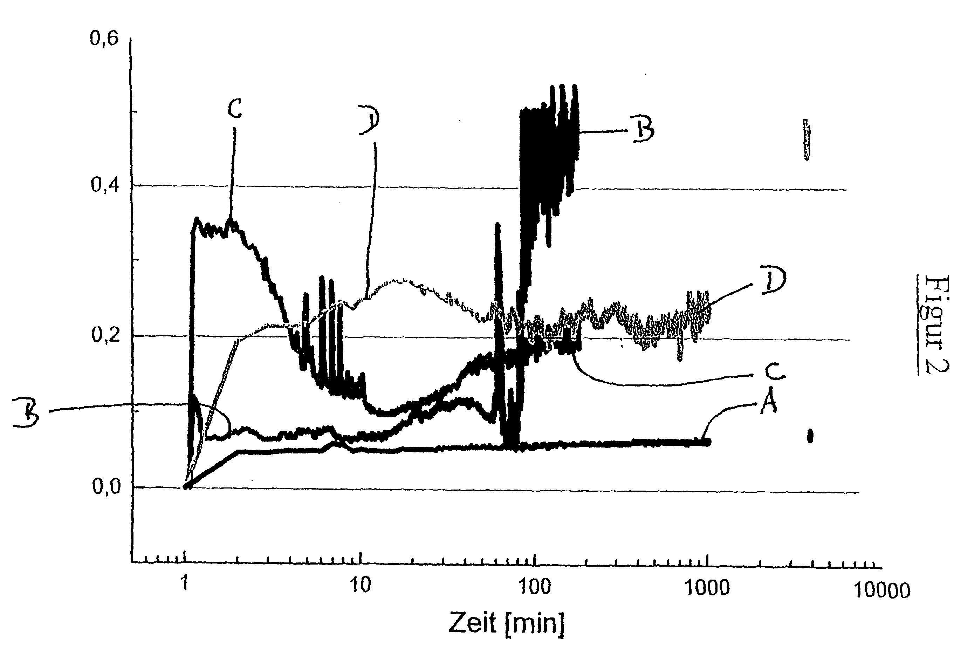

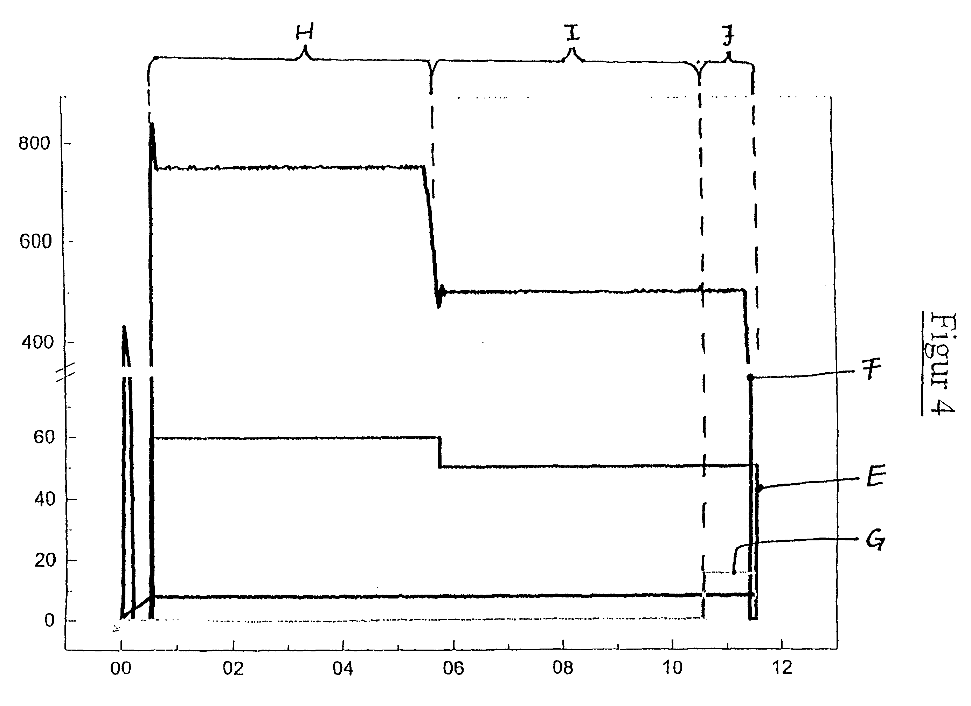

Nachfolgend wird das erfindungsgemäße Verfahren anhand eines in Figur 4 dargestellten Gasflußdiagramms beschrieben.

In Figur 4 ist ein Gasflußdiagramm verschiedener Gase über der Zeit dargestellt, wobei zusätzlich die Temperatur der zu beschichtenden Probe mit aufgetragen ist. Das Diagramm nach Figur 4 beschreibt den eingestellten Gasfluß im Reaktorinnern 13 während der Herstellung eines erfindungsgemäßen Schichtaufbaus auf einer metallischen Probe mittels eines Plasma-CVD-Prozesses.

Bei dem Plasma-CVD-Prozeß wird die Probe durch ein die Probe umgebendes Plasma 16 geheizt. Das die zu beschichtende Oberfläche 2 der Probe beheizende Plasma 16, das ebenfalls die Vormaterialien sowie das Prozeßgas zur Abscheidung bzw. zur Borierung aktiviert, wird durch eine an der Probe anliegende Spannung gezündet bzw. aufrechterhalten.

Zur Regelung der Temperatur wird die Temperatur der Probe (Kurve F) gemessen und dementsprechend die an der Probe anliegende elektrische Spannung für das u.a. heizend wirkenden Plasma 16 verändert. Die elektrische Spannung kann wie vorliegend eine reine Gleichspannung sein. Je nach Anforderungen an das Plasma 16 wird anstelle der Gleichspannung vorzugsweise eine gepulste Spannung, eine Wechselspannung oder eine halbwellige Wechselspannung angelegt.

Der Verlauf des Druckes p im Reaktorinnern ist in dem Diagramm nach Figur 4 als zweit untere, nicht einzel gekennzeichnete Kurve, der bei der Herstellung der Haftvermittler- und der Zwischen- und ebenfalls der Schmierstoffschicht mit dem Prozeßgas vermischte H₂-Fluß (5% B₂H₆ und 95% H₂) als Kurve E und der Sauerstoffluß der Kurve G entnehmbar. Die Werte der unterschiedlichen Gasflüsse beziehen sich auf die Einheit Standard-Kubikzentimeter (sccm). Da für das Bor liefernde zweite Vormaterial ebenfalls das borierend wirkende Prozeßgas verwendet wird, zeigt die Kurve F nach dem Borieren (Zeitintervall H) ebenfalls den Gasfluß des zweiten Vormaterials (Zeitintevall I). Während des Zeitintervalls J wird die Schmierstoffschicht aufgetragen.

Die Probe wird eventuell vor dem Einbau in den Reaktor 6 vorgereinigt und anschließend in den Reaktor 6 eingebaut. Danach wird das Reaktorinnere 13 bis auf einen Druck kleiner 0.5 mbar evakuiert. Zur Reinigung wird in das evakuierte Reaktorinne 13 des Reaktor 6 ca. 30 min ein H₂-Gas eingeleitet. Mit dem H₂-Gas wird in Bereich der Probe das Plasma 16 gezündet und die zu beschichtende Oberfläche 2 der Probe unter Zuhilfenahme des H₂-Plasma 16 gereinigt. Wie aus dem Diagramm nach Figur 4 ersichtlich ist, steigt bei der Reinigung der Probe der Druck im Reaktorinnern 13 auf einen Wert von ca. 10 mbar an. Dieser Wert wird bei der beschriebenen Herstellung des erfindungsgemäßen Schichtaufbau dieses Ausführungsbeispiels zumindest weitgehend beibehalten.

Nach der Reinigung der Oberfläche 2 der Probe wird sie für die Zeitdauer H von ca. 6 Stunden bei einer Temperatur von ca. 750 °C und einem mit 95% H₂ versetzten B₂H₆ Gasstrom von ca. 60 sccm aufgesetzt. Bei diesen Prozeßbedingungen wird die Haftvermittlerschicht 3 hergestellt. Dabei wird die Probe bei den eben genannten Bedingungen einige µm oberflächennah boriert. Durch die borierte Haftvermittlerschicht 3 ist die Haftung zwischen der anschließend aufzutragenden Zwischenschicht 4 sowie der später aufzutragenden Schmierstoffschicht 5 und dem Material der Probe (Gegenstandes 1) verbessert.

Nach dem Borieren wird die Temperatur auf ca. 500 °C abgesenkt und der Fluß des H₂-versetzten Prozeßgases auf einen Fluß von ca. 50 sccm gesenkt. Dadurch wird auf der Haftvermittlerschicht 3 für die Zeitdauer I von ca. 5 Stunden eine Borschicht hergestellt. Diese Borschicht gehört zu der Zwischenschicht 4.

Nach dem Aufwachsen der Borschicht wird in den Reaktor 6 zusätzlich für ca. 1 Stunde (Zeitdauer J) Sauerstoff und zwar mit einem Fluß von ca. 15 sccm eingeströmt, wobei die vorherigen Prozeßparameter (Gasflüsse, Temperatur und Druck) beibehalten werden. Hierbei bilden sich zuerst die Bor und Sauerstoff aufweisenden Bereiche der Zwischenschicht.

Anschließend wird die Temperatur abgesenkt und die restlichen Parameter konstant gehalten. Durch die Absenkung der Temperatur bricht das Plasma zusammen und der zuvor als Plasmabrennstoff verwendte Wasserstoff steht zur freien Verfügung. Hierdurchbildet sich bei Temperaturen unterhalb von ca. 200 °C und der Anwesenheit von Wasserstoff die weitgehend ausschließlich das Trockenschmiermittel Borsäure (H₃BO₃) aufweisende Schmierstoffschicht 5.

## Patentansprüche

1. Verfahren zum außenseitigen und haftenden Aufbringen einer Schmierstoffschicht auf eine freiliegende und tribologisch beanspruchte Oberfläche eines Gegenstandes, wobei die Schmierstoffschicht zumindest unter Beanspruchungsbedingungen Borsäure (H₃BO₃) aufweist,
**gekennzeichnet durch** die Gemeinsamkeit folgender Verfahrensschritte,
■ Einbau des zu beschichtenden und mit einer Haftvermittlerschicht versehenen Gegenstandes (1) in einen Reaktor, wobei **durch** die Haftvermittlerschicht (3) die Haftung zwischen dem später aufgetragenen Trockenschmierstoff der Schmierstoffschicht (5) und dem Material des Gegenstandes (1) verbessert wird,
■ Evakuieren des Reaktors (6) auf einen Druck kleiner 100 mbar, bevorzugt kleiner 10 mbar und besonders bevorzugt auf etwa 1 mbar, und/oder zumindest teilweises Befüllen des Reaktors (6) mit einem Inertgas,
■ Zugabe eines Bor zumindest als Verbindung aufweisenden und bei Prozeßbedingungen das Bor freigebenden zweiten Vormaterials in die abscheidende Gasphase,
■ Zugabe eines Sauerstoff zumindest als Verbindung aufweisenden und bei Prozeßbedingungen den Sauerstoff freigebenden ersten Vormaterials in die abscheidende Gasphase,
■ Herstellung einer Zwischenschicht (4) mit den Bor und Sauerstoff aufweisenden Vormaterialien auf der Haftvermittlerschicht (3) und
■ wenigstens im Einsatzfalle zumindest teilweise Umwandlung von Bor und Sauerstoff in der Bor und Sauerstoff aufweisenden Zwischenschicht (4) zumindest im Bereich ihrer frei zugänglichen Oberfläche zur Bildung von Borsäure als Trockenschmiermittel der Schmierstoffschicht (5) unter Zuhilfenahme von Wasserstoff.

2. Verfahren nach Anspruch 1,
**dadurch gekennzeichnet,**
**dass** der Gegenstand (1) erst nach seinem Einbau in den Reaktor (6) mit der Haftvermittlerschicht (3) versehen wird, dass ein Bor und/oder Stickstoff und/oder Kohlenstoff zumindest als Verbindung aufweisendes und bei Prozeßbedingungen das entsprechende Element freigebendes Prozeßgas in den evakuierten und/oder zumindest teilweise mit einem Inertgas befüllten Reaktor eingeleitet wird, und dass zur Herstellung der Haftvermittlerschicht (3) im Bereich der freiliegenden Oberfläche (2) des Gegenstandes (1), insbesondere durch Diffusion, zumindest ein Element des Prozeßgases in das Material der freiliegenden Oberfläche (2) des Gegenstandes (1) eingebracht und dort eingebaut und/oder chemisch reagiert wird.

3. Verfahren nach Anspruch 2,
**dadurch gekennzeichnet,**
**dass** zur Herstellung der Haftvermittlerschicht (3) zumindest ein Element des Prozeßgases in das Material der freiliegenden und zu beschichtenden Oberfläche (2) des Gegenstandes (1) eindiffundiert und/oder ionenimplantiert wird.

4. Verfahren nach Anspruch 1,
**dadurch gekennzeichnet,**
**dass** unter der Bor und Sauerstoff aufweisenden Zwischenschicht (4) als Bestandteil der Haftvermittlerschicht (3) TiN und/oder TiC und/oder Ti(C,N) abgeschieden wird.

5. Verfahren nach Anspruch 1,
**dadurch gekennzeichnet,**
**dass** die Haftvermittlerschicht (3) boriert und/oder nitriert und/oder carbonisiert und/oder carbonitriert wird.

6. Verfahren nach Anspruch 1,
**dadurch gekennzeichnet,**
**dass** zur Bildung der Borsäure Wasserstoff und/oder eine unter Prozeßbedingungen Wasserstoff freigebende Wasserstoffverbindung aus der abscheidenden Gasphase verwendet wird.

7. Verfahren nach Anspruch 1,
**dadurch gekennzeichnet,**
**dass** im Bereich der oberflächennahen Haftvermittlerschicht (3) des Gegenstandes (1) Boride gebildet werden.

8. Verfahren nach Anspruch 1,
**dadurch gekennzeichnet,**
**dass** die Prozeßgase und/oder die Vormaterialien vor ihrem Auftreffen auf der zu beschichtenden Oberfläche (2) des Gegenstandes (1) durch ein Plasma (16) hindurchgeleitet und zumindest zum Teil dissoziert und/oder ionisiert werden.

9. Verfahren nach Anspruch 8,
**dadurch gekennzeichnet,**
**dass** das Plasma (16) im Bereich der zu beschichtenden Oberfläche (2) des Gegenstandes (1) erzeugt wird und dass mit dem Plasma zumindest die zu beschichtenden Oberfläche des Gegenstandes (1) beheizt wird.

10. Verfahren nach Anspruch 1,
**dadurch gekennzeichnet,**
**dass** der Gegenstand (1) während der Bildung der Haftvermittlerschicht (3) durch Einbringen von Boratomen und/oder von Kohlenstoffatomen und/oder von Stickstoffatomen und/oder während des Abscheidens der Bor/Sauerstoffschicht insbesondere auf Temperaturen kleiner 750 °C, vorzugsweise kleiner 700 °C und besonders bevorzugt kleiner 600 °C beheizt wird.

11. Verfahren nach Anspruch 1,
**dadurch gekennzeichnet,**
**dass** während der zumindest oberflächennahen und wenigstens teilweisen Umwandlung der Bor und Sauerstoff aufweisenden Zwischenschicht (4) in Borsäure zum Herstellen der Schmierstoffschicht (5) die Temperatur gesenkt wird.

12. Verfahren nach Anspruch 5,
**dadurch gekennzeichnet,**
**dass** als Prozeßgas zum Einbringen des Bors und/oder zur Abscheidung der Bor und Sauerstoff aufweisenden Zwischenschicht (4) eine bei den jeweiligen Prozeßbedingungen gasförmige Borverbindung eingeleitet wird, deren Dissoziationstemperatur bei den vorliegenden Prozeßbedingungen maximal der herrschenden Prozeßtemperatur entspricht.

13. Verfahren nach Anspruch 5,
**dadurch gekennzeichnet,**
**dass** als Prozeßgas zum Einbringen des Bor und/oder zur Abscheidung der Bor und Sauerstoff aufweisenden Zwischenschicht (4) Boran (BₙHₘ), vorzugsweise Diboran (B₂H₆), Borchlorid (BCl₃) oder Borfluorid (BF₃) oder ein Gemisch zumindest zweier dieser Gase in den Reaktor (6) eingeleitet wird.

14. Verfahren nach Anspruch 1,
**dadurch gekennzeichnet,**
**dass** die Bor und Sauerstoff aufweisende Zwischenschicht (4) gleich bei Ihrer Herstellung aus der Gasphase zumindest teilweise in Borsäure umgewandelt wird.

15. Verfahren nach Anspruch 1,
**dadurch gekennzeichnet,**
**dass** während der Herstellung der Haftvermittlerschicht (3) und/oder Bor und Sauerstoff aufweisenden Zwischenschicht (4) und/oder der Schmierstoffschicht (5) an den Gegenstand (1) eine elektrische Spannung angelegt wird.

16. Verfahren nach Anspruch 15,
**dadurch gekennzeichnet,**
**dass** als elektrische Spannung eine gepulste DC-Spannung gewählt wird.

17. Verfahren nach Anspruch 15 und 8,
**dadurch gekennzeichnet,**
**dass** an den Gegenstand (1) ein elektrisches Potential angelegt wird, das gegenüber dem ihn umgebenden Gasraum negativ ist.

18. Verfahren nach Anspruch 1,
**dadurch gekennzeichnet,**
**dass** als Bor und Sauerstoff aufweisende Zwischenschicht (4) Boroxid, insbesondere B₂O₃ aufgetragen wird.

19. Verfahren nach Anspruch 1,
**dadurch gekennzeichnet,**
**dass** die Schmierstoffschicht (5) mit mindestens 30 %, bevorzugt mindestens 50 % und besonders bevorzugt mindestens 60 % Borsäure versehen wird.

20. Verfahren nach Anspruch 1,
**dadurch gekennzeichnet,**
**dass** die Schmierstoffschicht (5) mit mindestens 80 %, bevorzugt mindestens 90 % und besonders bevorzugt mindestens 95 % Borsäure versehen wird.

21. Verfahren nach Anspruch 1,
**dadurch gekennzeichnet,**
**dass** für die Zwischenschicht (4) B₆O und/oder B₂O₃ aufgetragen wird.

22. Verfahren nach Anspruch 1,
**dadurch gekennzeichnet,**
**dass** für die Zwischenschicht (4) zuerst B₆O und anschließend B₂O₃ aufgetragen wird, wobei vor dem B₆O vorzugsweise zuerst noch Bor aufgetragen wird.

23. Verfahren nach Anspruch 5,
**dadurch gekennzeichnet,**
**dass** als Gegenstand (1) ein metallischer, insbesondere Eisen aufweisender Gegenstand (1) gewählt wird und dass als Borid der Haftvermittlerschicht (3) ein Metallborid, vorzugsweise Fe₂B und/oder FeB, gebildet wird.

24. Verfahren nach Anspruch 1,
**dadurch gekennzeichnet,**
**dass** ein eine metallische Legierung, bevorzugt eine Leichtmetall-Legierung und besonders bevorzugt eine Titan-Legierung und/oder eine Aluminium-Legierung und/oder eine Magnesium-Legierung aufweisender Gegenstand (1) gewählt wird.

25. Verfahren nach Anspruch 1,
**dadurch gekennzeichnet,**
**dass** als Haftvermittlerschicht (3) auf der zu beschichtenden Oberfläche (2) des Gegenstandes (1) eine Bor und Kohlenstoff, bevorzugt eine Borcarbid-Schicht (B₄C)abgeschieden wird.

26. Verfahren nach Anspruch 1,
**dadurch gekennzeichnet,**
**dass** die oberhalb der Haftvermittlerschicht (3) abgeschiedene Zwischenschicht (4) mit einem Sauerstoffgradienten abgeschieden wird, der mit zunehmendem Abstand von der Haftvermittlerschicht (3) hin zunimmt.

27. Verfahren nach Anspruch 23,
**dadurch gekennzeichnet,**
**dass** das FeB im Verhältnis zu allen Eisenboriden mit einem Anteil kleiner 20 %, bevorzugt kleiner 10 % und besonders bevorzugt kleiner 1% gebildet wird.

28. Verfahren nach Anspruch 1,
**dadurch gekennzeichnet,**
**dass** nach der Bildung von Fe₂B im Bereich der zu beschichtenden Oberfläche (2) des Gegenstandes (1) der Anteil von Bor in der abscheidenden Gasphase innerhalb von 5 s um wenigstens 20 % erhöht wird.

29. Verfahren nach Anspruch 1,
**dadurch gekennzeichnet,**
**dass** nach der Bildung von Pe₂B im Bereich der zu beschichtenden Oberfläche (2) des Gegenstandes (1) zumindest die oberflächennahe Temperatur des Gegenstandes (1) abgesenkt wird.

30. Gegenstand mit einer an einer freiliegenden und zu beschichtenden Oberfläche haftenden Schmierstoffschicht, welche zumindest im Einsatzfall wenigstens bereichsweise Borsäure als Trockenschmiermittel aufweist,
**dadurch gekennzeichnet,**
**daß** unterhalb der Schmierstoffschicht (5) eine Haftvermittlerschicht (3) angeordnet ist, daß die Haftvermittlerschicht (3) Bor und/oder Kohlenstoff und/oder Stickstoff aufweist, daß die Schmierstoffschicht (5) aus einer Gasphase aufgetragen ist, daß zwischen der Schmierstoffschicht (5) und der Haftvermittlerschicht (3) eine Zwischenschicht (4) angeordnet ist, daß die Zwischenschicht (4) Bor und Sauerstoff aufweist und daß die Zwischenschicht (4) einen Sauerstoffgradienten aufweist, der mit zunehmendem Abstand von der Haftvermittlerschicht (3) hin zunimmt.

31. Gegenstand nach Anspruch 30,
**dadurch gekennzeichnet,**
**daß** die Schmierstoffschicht (5) zumindest oberflächennah mindestens 5%, bevorzugt 10 % und besonders bevorzugt 30 % Borsäure (H₃BO₃) aufweist.

32. Gegenstand nach Anspruch 30,
**dadurch gekennzeichnet,**
**daß** die Haftvermittlerschicht (3) als borierte und/oder carbonisierte und/oder nitrierte und/oder carbonitrierte Schicht ausgebildet ist.

33. Gegenstand nach Anspruch 30,
**dadurch gekennzeichnet,**
**daß** die Zwischenschicht (4) Bor, B₆O und B₂O₃ aufweist.

34. Gegenstand nach Anspruch 30,
**dadurch gekennzeichnet,**
**daß** die Zwischenschicht (4) beginnend von der Haftvermittlerschicht (3) zuerst Bor nachfolgend B₆O und darauf nachfolgend B2O3 aufweist, wobei das B₂O₃ in direktem Kontakt zu der Schmierstoffschicht (5) angeordnet ist.

35. Verwendung eines mit dem Verfahrens gemäß Anspruch 1 beschichteten Gegenstandes (1) für zumindest eine bereichsweise Beschichtungen von abrasiv beanspruchten Laufflächen von Bauteilen, für Motorbauteile, insbesondere für Nockenwellen, Kipphebel, Tassenstößel, Laufbuchsen, Ventilbrücken, Ventilschäfte, Ventillaufbuchsen bzw. -führungen, Kolbenbolzen, Kolbenringe, Zylinderlaufflächen, Pleuel, Anlaufscheiben und Zahnräder, insbesondere von Getrieben, sowie für Kettenglieder oder Riemenscheiben für stufenlose Getriebe.

36. Verwendung eines mit dem Verfahrens gemäß Anspruch 1 beschichteten Gegenstandes (1) für zumindest eine bereichsweise Beschichtung von spanend eingreifenden Spanflächen spanabhebender Werkzeuge mit definierten Schneidengeometrien, insbesondere für Fräser, Drehstähle, Wendeschneideplatten, Bohrer, sowie für Werkzeugen zum Reiben und Räumen.

37. Verwendung eines mit dem Verfahrens gemäß Anspruch 1 beschichteten Gegenstandes (1) für zumindest eine bereichsweise Beschichtung für abrasiv beanspruchte Formwerkzeuge, insbesondere für Umformwerkzeugen wie Tiefziehpressen.

## Claims

1. Process for the external application of an adhering lubricant layer on a free and tribologically stressed surface of an object, such that at least under load conditions the lubricant contains boric acid (H₂BO₃),
**characterised by**
the combination of processing steps as follows:
■ positioning of the object (1) to be coated, which has been provided with an adhesion-promoting layer, in a reactor, such that by virtue of the adhesion-promoting layer (3) the adhesion between the dry lubricant of the lubricant layer (5) applied later and the material of the object (1) is improved;
■ evacuation of the reactor (6) to a pressure lower than 100 mbar, preferably lower than 10 mbar and particularly preferably about 1 mbar, and/or at least partial refilling of the reactor (6) with an inert gas;
■ addition to the precipitating gas phase of a second starting material containing boron at least in the form of a compound that releases the boron under process conditions;
■ addition to the precipitating gas phase of a first starting material containing oxygen at least in the form of a compound that releases the oxygen under process conditions;
■ production of an intermediate layer (4) over the adhesion-promoting layer (3) with the starting materials that contain the boron and oxygen, and
■ at least during use, at least partial transformation of the boron and oxygen in the intermediate layer (4) containing boron and oxygen, at least in the area of the freely accessible surface, to form boric acid as the dry lubricant medium of the lubricant layer (5), with the aid of hydrogen.

2. Process according to Claim 1,
**characterised in that**
the object (1) is only provided with the adhesion-promoting layer (3) once it has been positioned in the reactor (6), and a process gas containing boron and/or nitrogen and/or carbon at least in the form of a compound that releases the corresponding element under process conditions is admitted to the reactor that has been evacuated and/or at least partly refilled with an inert gas, and that to produce the adhesion-promoting layer (3) in the area of the free surface (2) of the object (1), in particular by diffusion, at least one element of the process gas is applied on the material of the free surface (2) of the object (1) and is there incorporated and/or chemically reacted.

3. Process according to Claim 2,
**characterised in that**
to produce the adhesion-promoting layer (3) at least one element of the process gas is diffused and/or ion-implanted into the material of the free surface (2) of the object (1) to be coated.

4. Process according to Claim 1,
**characterised in that**
TiN and/or TiC and/or Ti(C, N) is/are deposited under the intermediate layer (4) as part of the adhesion-promoting layer (3).

5. Process according to Claim 1,
**characterised in that**
the adhesion-promoting layer (3) is borided and/or nitrided and/or carburised and/or carbonitrided.

6. Process according to Claim 1,
**characterised in that**
to form the boric acid, hydrogen and/or a hydrogen compound that releases hydrogen under process conditions from the precipitating process gas is used.

7. Process according to Claim 1,
**characterised in that**
borides are formed in the area of the adhesion-promoting layer (3) on the article (1) close to its surface.

8. Process according to Claim 1,
**characterised in that**
before impinging on the surface (2) of the object (1) to be coated, the process gases and/or the starting materials pass through a plasma (16) and are at least partially dissociated and/or ionised.

9. Process according to Claim 8,
**characterised in that**
the plasma (16) is produced in the area of the surface (2) of the object (1) to be coated, and at least the surface of the object (1) to be coated is heated by the plasma.

10. Process according to Claim I,
**characterised in that**
during the formation of the adhesion-promoting layer (3) by the provision of boron atoms and/or carbon atoms and/or nitrogen atoms, and/or during the deposition of the boron/oxygen layer, the object (1) is heated in particular to temperatures lower than 750°C, preferably lower than 700°C and especially preferably lower than 600°C.

11. Process according to Claim 1,
**characterised in that**
during the at least partial transformation of the intermediate layer (4) containing boron and oxygen, at least near the surface, into boric acid in order to produce the lubricant layer (5), the temperature is lowered.

12. Process according to Claim 5,
**characterised in that**
as the process gas for providing the boron and/or for precipitating the intermediate layer (4) containing boron and oxygen, a boron compound that is gaseous under the process conditions in question is introduced, whose dissociation temperature under the prevailing process conditions corresponds at most to the prevailing process temperature.

13. Process according to Claim 5,
**characterised in that**
as the process gas for providing the boron and/or for precipitating the intermediate layer (4) containing boron and oxygen, a borane (BₙHₘ), preferably diborane (B₂H₆), boron chloride (BCl₃), boron fluoride (BF₃) or a mixture of at least two of these gases is introduced into the rector (6).

14. Process according to Claim 1,
**characterised in that**
during its production from the gaseous phase, the intermediate layer (4) containing boron and oxygen is also transformed into boric acid, at least in part.

15. Process according to Claim 1,
**characterised in that**
during the production of the adhesion-promoting layer (3) and/or the intermediate layer (4) containing boron and oxygen and/or the lubricant layer (5), an electrical voltage is applied to the object (1).

16. Process according to Claim 15,
**characterised in that**
as the electrical voltage, a pulsed DC voltage is chosen.

17. Process according to Claims 15 and 8,
**characterised in that**
an electrical potential is applied to the object (1), which is negative relative to its gaseous surroundings.

18. Process according to Claim 1,
**characterised in that**
boron oxide, in particular B₂O₃ is applied as the intermediate layer (4) containing boron and oxygen.

19. Process according to Claim 1,
**characterised in that**
the lubricant layer (5) contains at least 30%, preferably at least 50% and particularly preferably at least 60% of boric acid.

20. Process according to Claim 1,
**characterised in that**
the lubricant layer (5) contains at least 80%, preferably at least 90% and particularly preferably at least 95% of boric acid.

21. Process according to Claim 1,
**characterised in that**
B₆O and/or B₂O₃ it/are applied as the intermediate layer (4).

22. Process according to Claim 1,
**characterised in that**
for the intermediate layer (4) B₆O is applied first and B₂O₃ is applied subsequently, and preferably, before the B₆O, boron is also applied first.

23. Process according to Claim 5,
**characterised in that**
as the object (1) a metallic object (1) is chosen, in particular one containing iron, and as the boride of the adhesion-promoting layer (3) a metal boride is formed, preferably Fe₂B and/or FeB.

24. Process according to Claim 1,
**characterised in that**
the object (1) chosen is one that consists of a metallic alloy, preferably a light-metal alloy and particularly preferably a titanium alloy and/or an aluminium alloy and/or a magnesium alloy.

25. Process according to Claim 1,
**characterised in that**
as the adhesion-promoting layer (3), a boron and carbon layer, preferably a layer of boron carbide (B₄C) is deposited on the surface (2) of the object (1) to be coated.

26. Process according to Claim 1,
**characterised in that**
the intermediate layer (4) deposited over the adhesion-promoting layer (3) is deposited with an oxygen gradient which increases with increasing distance from the adhesion-promoting layer (3).

27. Process according to Claim 23,
**characterised in that**
in relation to any other iron boride, FeB is formed in a proportion lower than 20%, preferably lower than 10% and especially preferably lower than 1%.

28. Process according to Claim 1,
**characterised in that**
after the formation of Fe₂B in the area of the surface (2) of the object (1) to be coated, the proportion of boron in the precipitating gas phase is increased by at least 20% within 5 s.

29. Process according to Claim 1,
**characterised in that**
after the formation of Fe₂B in the area of the surface (2) of the object (1) to be coated, at least the temperature of the object (1) near its surface is lowered.

30. Object with a lubricant layer that adheres to a free surface to be coated therewith, which at least during use contains boric acid as a dry lubricant material, at least in some areas, **characterised in that**
under the lubricant layer (5) there is an adhesion-promoting layer (3), the said adhesion-promoting layer (3) contains boron and/or carbon and/or nitrogen, the said lubricant layer (5) is applied from a gas phase, between the lubricant layer (5) and the adhesion-promoting layer (3) there is an intermediate layer (4), the said intermediate layer (4) contains boron and oxygen, and the intermediate layer (4) has an oxygen gradient which increases with increasing distance from the adhesion-promoting layer (3).

31. Object according to Claim 30,
**characterised in that**
at least near the surface, the lubricant layer (5) contains at least 5%, preferably 10% and especially preferably 30% of boric acid (H₃BO₃).

32. Object according to Claim 30,
**characterised in that**
the adhesion-promoting layer (3) is formed as a bonded and/or carburised and/or nitrided and/or carbonitrided layer.

33. Object according to Claim 30,
**characterised in that**
the intermediate layer (4) contains boron, B₆O and B₂O₃.

34. Object according to Claim 30,
**characterised in that**
beginning from the adhesion-promoting layer (3), the intermediate layer (4) contains first boron, thereafter B₆O and after that B₂O₃, and the B₂O₃ is positioned in direct contact with the lubricant layer (5).

35. Use of an object (1) coated by the process according to Claim 1 for at least the local coating of abrasively stressed sliding surfaces of engine components, in particular camshafts, rocker arms, cup tappets, cylinder liners, valve bridges, valve stems, valve hole liners or guides, piston pins, piston rings, cylinder liners, connecting rods, thrust washers and gear wheels, in particular those of transmissions, and for chain links or belt discs for continuous transmissions.

36. Use of an object (1) coated by the process according to Claim 1 for at least the local coating of the chip-clearing rake surfaces of tools with a defined cutter geometry, in particular milling tools, turning steels, multiple-edged cutters, boring tools, and for tools used for reaming and broaching.

37. Use of an object (1) coated by the process according to Claim 1 for at least the local coating of abrasively loaded shaping tools, in particular for deformation tools such as deep-drawing presses.

## Revendications

1. Procédé pour apposer, sur le côté extérieur et de façon adhérente, une couche de lubrifiant sur une surface d'un objet, qui est dégagée et est soumise à une contrainte tribologique, la couche de lubrifiant possédant, au moins dans des conditions de contrainte, de l'acide borique (H₃BO₃),
**caractérisé par** la combinaison des étapes opératoires suivantes
• mise en place de l'objet (1) devant être recouvert et pourvu d'une couche d'adhésif, dans un réacteur, l'adhérence entre le lubrifiant sec, appliqué ultérieurement, de la couche de lubrifiant (5) et le matériau de l'objet (1) étant améliorée au moyen de la couche d'adhésif (3),
• établissement d'un vide dans le réacteur (6) à une pression inférieure à 100 mbars et de préférence inférieure à 10 mbars et d'une manière particulièrement préférentielle à environ 1 mbar et/ou au moins un remplissage partiel du réacteur (6) par un gaz inerte,
• addition d'un second produit primaire comportant du bord au moins en tant que composé et libérant le bord dans des conditions de traitement, dans la phase gazeuse qui se dépose,
• addition d'un premier matériau primaire, qui contient de l'oxygène au moins en tant que composé et libère l'oxygène dans des conditions de traitement, dans la phase gazeuse qui se dépose,
• fabrication d'une couche intercalaire (4) avec le bore et avec des matériaux primaires contenant du bore et de l'oxygène, sur la couche d'adhésif (3), et
• au moins dans le cas d'utilisation, conversion au moins partielle du bore et de l'oxygène situé dans la couche intercalaire (4) contenant du bore et de l'oxygène, au moins dans la zoné de leur surface librement accessible pour la formation d'acide borique en tant que lubrifiant sec de la couche de lubrifiant (5), et ce à l'aide d'hydrogène.

2. Procédé selon la revendication 1, **caractérisé en ce que** l'on pourvoit l'objet (1) de la couche d'adhésif (3) uniquement après sa mise en place dans le réacteur (6), qu'on introduit le gaz de traitement, qui contient du bore et/ou de l'oxygène et/ou de l'hydrogène en tant que composé, et qui libère l'élément correspondant dans les conditions de traitement, dans le réacteur dans lequel un vide est créé et/ou qui est rempli partiellement par un gaz inerte, et que pour la fabrication de la couche d'adhésif (3) dans la zone de la surface dégagée (2) de l'objet (1) on insère, notamment par diffusion, au moins un élément du gaz de traitement dans le matériau de la surface libérée (2) de l'objet (1) et on le fixe dans le matériau et/ou on le fait réagir chimiquement.

3. Procédé selon la revendication 2, **caractérisé en ce que** pour la fabrication de la couche d'adhésif (3), on réalise la diffusion et/ou l'implantation ionique d'au moins un élément du gaz de traitement dans le matériau de la surface dégagée et à recouvrir (2) de l'objet (1).

4. Procédé selon la revendication 1, **caractérisé en ce qu'**au-dessous de la couche intercalaire (4) contenant le bore et l'oxygène, on dépose, en tant que constituant de la couche d'adhésif (3), du TiN et/ou du TiC et/ou du Ti(C,N).

5. Procédé selon la revendication 1, **caractérisé en ce qu'**on réalise une boruration et/ou une nitruration et/ou une carburation et/ou une carbonitruration de la couche d'adhésif (3).

6. Procédé selon la revendication 1, **caractérisé en ce que** pour la formation de l'acide borique, on utilise de l'hydrogène et/ou un composé d'hydrogène, qui libère de l'hydrogène dans des conditions de traitement, à partir de la phase gazeuse qui se dépose.

7. Procédé selon la revendication 1, **caractérisé en ce qu'**on forme des borures dans la zone de la couche d'adhésif (3), proche de la surface, de l'objet (1).

8. Procédé selon la revendication 1, **caractérisé en ce que** les gaz de traitement et/ou les matériaux primaires, passent à travers un plasma (16) et sont au moins en partie dissociés et/ou ionisés avant de rencontrer la surface à recouvrir (2) de l'objet (1).

9. Procédé selon la revendication 8, **caractérisé en ce que** le plasma (16) est produit dans la zone de la surface à recouvrir (2) de l'objet (1) et qu'au moins la surface à recouvrir de l'objet (1) est chauffé avec le plasma.

10. Procédé selon la revendication 1, **caractérisé en ce que** pendant la formation de la couche d'adhésif (3), l'objet (1) est chauffé par l'introduction d'atomes de bore et/ou d'atomes de carbone et/ou d'atomes d'oxygène et/ou pendant le dépôt de la couche de bore/d'oxygène, notamment à des températures inférieures à 750°C, de préférence inférieures à 700°C et d'une manière particulièrement préférable inférieures à 600°C.

11. Procédé selon la revendication 1, **caractérisé en ce que** pendant la conversion, qui s'effectue au moins à proximité de la surface et est au moins partielle de la couche intercalaire (4) contenant du bore et le l'oxygène, en acide borique pour former la couche de lubrifiant (5), on abaisse cette température.

12. Procédé selon la revendication 5, **caractérisé en ce qu'**en tant que gaz de traitement pour l'introduction de bore et/ou le dépôt de la couche intercalaire (4) contenant du bore et de l'oxygène, on introduit un composé de bore sous forme gazeuse dans les conditions respectives de traitement, dont la température de dissociation correspond au maximum à la température de traitement qui règne, dans les conditions présentes de traitement.

13. Procédé selon la revendication 5, **caractérisé en ce qu'**on introduit comme gaz de traitement servant à introduire du bore et/ou à déposer la couche intercalaire (4) contenant du bore et de l'oxygène, du borane (BₙHₘ), de préférence du diborane (B₂H₆), du chlorure de bore (BCl₃) ou du fluorure de bore (BF₃) ou un mélange au moins de deux de ces gaz dans le réacteur (6).

14. Procédé selon la revendication 1, **caractérisé en ce que** la couche intercalaire (4) contenant du bore et de l'oxygène est convertie comme dans le cas de sa fabrication, à partir de la phase gazeuse, au moins en partie en acide borique.

15. Procédé selon la revendication 1, **caractérisé en ce que** pendant la fabrication de la couche d'adhésif (3) et/ou de la couche intercalaire (4) contenant du bore et de l'oxygène et/ou de la couche de lubrifiant (5), on applique à l'objet (1) une tension électrique.

16. Procédé selon la revendication 15, **caractérisé en ce qu'**on choisit comme tension électrique une tension continue pulsée.

17. Procédé selon les revendications 15 et 8, **caractérisé en ce qu'**on applique à l'objet (1) un potentiel électrique, qui est négatif par rapport à l'espace de gaz qui l'entoure.

18. Procédé selon la revendication 1, **caractérisé en ce qu'**on dépose de l'oxyde de bore, notamment du B₂O₃, en tant que couche intercalaire (15) contenant du bore et de l'oxygène.

19. Procédé selon la revendication 1, **caractérisé en ce** la couche de lubrifiant (5) est pourvue d'au moins 30 % et de préférence d'au moins 50 % et de façon particulièrement préférée d'environ 60 % d'acide borique.

20. Procédé selon la revendication 1, **caractérisé en ce que** la couche de lubrifiant (5) est pourvue d'au moins 80 %, de préférence d'au moins 90 % et de façon particulièrement préférentielle d'au moins 95 % de l'acide borique.

21. Procédé selon la revendication 1, **caractérisé en ce** pour la couche intercalaire (4) on dépose du B₆O et/ou du B₂O₃.

22. Procédé selon la revendication 1, **caractérisé en ce que** pour la couche intercalaire (4) on dépose tout d'abord du B₆O puis du B₂O₃, et avant le B₆O on dépose de préférence tout d'abord également du bore.

23. Procédé selon la revendication 5, **caractérisé en ce qu'**on choisit comme objet (1) un objet métallique (1), contenant notamment du fer, et qu'on forme en tant que borure de la couche d'adhésif (3), un borure métallique, de préférence du Fe₂B et/ou du FeB.

24. Procédé selon la revendication 1, **caractérisé en ce qu'**on choisit un objet (1) comportant un alliage métallique, de préférence un alliage de métal léger et d'une manière particulièrement préférée un alliage de titane, et/ou un alliage d'aluminium et/ou un alliage de manganèse.

25. Procédé selon la revendication 1, **caractérisé en ce qu'**on dépose comme couche d'adhésif (3) sur la surface à recouvrir (2) de l'objet (1) du bore et du carbone, de préférence une couche de carbure de bore (B₄C).

26. Procédé selon la revendication 1, **caractérisé en ce que** la couche intercalaire (4) déposée au-dessus de la couche d'adhésif (3) est déposée avec un gradient d'oxygène, qui augmente lorsque la distance par rapport à la couche d'adhésif (4) augmente.

27. Procédé selon la revendication 23, **caractérisé en ce que** le FeB est formé dans le rapport par rapport à tous les borures de fer selon un pourcentage inférieur à 20 %, de préférence inférieur à 10 % et d'une manière particulièrement préférée inférieur à 1 %.

28. Procédé selon la revendication 1, **caractérisé en ce qu'**après la formation de Fe₂B de la zone de la surface à recouvrir (2) de l'objet (1) le pourcentage de bore dans la phase gazeuse qui se dépose est accru d'au moins 20 % en l'espace de 5 s.

29. Procédé selon la revendication 1, **caractérisé en ce qu'**après la formation de Fe₂B dans la zone de la surface à recouvrir (2) de l'objet (1), on réduit au moins la température, proche de la surface, de l'objet (1).

30. Objet comportant une couche de lubrifiant, qui adhère à une surface dégagée et devant être recouverte, et qui comporte au moins dans le cas de l'utilisation au moins par endroit de l'acide borique en tant que lubrifiant sec, **caractérisé en ce qu'**au-dessous de la couche de lubrifiant (5) est disposée une couche d'adhésif (3), que la couche d'adhésif (3) contient du bore et/ou du carbone et/ou de l'azote, que la couche de lubrifiant (5) est déposée à partir d'une phase gazeuse, qu'une couche intercalaire (4) est disposée entre la couche de lubrifiant (5) et la couche d'adhésif (3), que la couche intercalaire (4) contient du bore et de l'oxygène et que la couche intercalaire (4) comporte un gradient d'oxygène qui augmente lorsque la distance par rapport à la couche d'adhésif (3) augmente.

31. Objet selon la revendication 30, **caractérisé en ce que** la couche de lubrifiant (5) possède au moins à proximité de la surface au moins 5 %, de préférence 10 % et d'une manière particulièrement préférable 30 % d'acide borique (H₃BO₃).

32. Objet selon la revendication 30, **caractérisé en ce que** la couche d'adhésif (3) est agencée sous la forme d'une couche borurée et/ou carburée et/ou nitrurée et/ou carbonitrurée.

33. Objet selon la revendication 30, **caractérisé en ce que** la couche intercalaire (4) comporte du bore, du B₆O et du B₂O₃.

34. Objet selon la revendication 30, **caractérisé en ce que** la couche intercalaire (4) comporte, en commençant à partir de la couche d'adhésif (3), tout d'abord du bore, puis du B₆O et ensuite, par-dessus, du B₂O₃, le B₂O₃ étant placé en contact direct avec la couche de lubrifiant (5).

35. Utilisation d'un objet (1) recouvert à l'aide du procédé selon la revendication 1, pour au moins un revêtement au moins par zone de surface de circulation, sollicitée avec abrasion, de composants, pour des composants de moteurs, notamment des arbres à cames, des culbuteurs, des poussoirs à coupelle, des chemises de cylindres, des plaquettes de soupapes, des tiges de soupapes, des chemises ou des guides de soupapes, des axes de pistons, des segments de pistons, des surfaces de cylindres, des bielles, des plaques de butée et des pignons, notamment de boîtes de vitesses, ainsi que pour des maillons ou des éléments de chaînes ou des poulies pour des boîtes de vitesses progressives.

36. Utilisation d'un objet (1) recouvert à l'aide du procédé selon la revendication 1, pour au moins un revêtement par endroits de surfaces d'engagement avec enlèvement de copeaux d'outils de travail avec enlèvement de copeaux possédant des géométries de coupe définies, notamment pour des fraises, des outils de tournage, des plaquettes de coupe réversibles, des forets ainsi que pour des outils de frottement et de nettoyage.

37. Utilisation d'un objet (1) recouvert à l'aide du procédé selon la revendication 1, pour former au moins un revêtement par endroits pour des outils de moulage soumis à des contraintes d'abrasion, notamment pour des outils de formage tels que des presses d'emboutissage.
